# FASCICULE DE BREVET EUROPEEN

(11) **EP 3 603 927 B1**
(45) Date de publication et mention de la délivrance du brevet: **19.07.2023**
(21) Numéro de dépôt: 19189658.8
(22) Date de dépôt: 01.08.2019
(51) Int. Cl.: B29C 45/14

(54) **PROCÉDÉ DE FABRICATION D'UNE PIÈCE PLASTIQUE FORMANT UNE INTERFACE DE COMMANDE HOMME-MACHINE**
HERSTELLUNGSVERFAHREN EINES PLASTIKTEILS, DAS ALS MENSCH-MASCHINEN-STEUERSCHNITTSTELLE FUNGIERT
METHOD FOR MANUFACTURING A PLASTIC PART FORMING A HUMAN-MACHINE CONTROL INTERFACE

(30) Priorité: 02.08.2018 FR 1857255
(43) Date de publication de la demande: 05.02.2020
(73) Titulaire: Commissariat à l'énergie atomique et aux énergies alternatives, 75015 Paris (FR); Symbiose, 33500 Arveyres (FR)
(72) Inventeur: LATOUR, Antoine, 38170 Seyssinet-Pariset (FR); GRAS, Antoine, 33240 Val-de-Virvée (FR); PAWLAK, Sébastien, 42660 Saint Genest Malifaux (FR)
(74) Mandataire: Brevalex

(56) Documents cités:
- WO-A1-2013/058708
- DE-U1- 29 824 038
- US-A1- 2015 016 144

## Description

### DOMAINE TECHNIQUE

La présente invention se rapporte au domaine général des interfaces homme-machine, et plus spécifiquement les interfaces homme-machine qui sont intégrées dans des pièces plastiques.

De manière générale, l'invention trouve des applications dans tout domaine de l'industrie pour lesquels des surfaces plastiques nécessitent une interface homme-machine. En particulier, l'invention peut être appliquée à toute interface pour laquelle les boutons poussoirs mécaniques sont remplacés par des surfaces tactiles, par exemple pour une console centrale d'un véhicule. Dans ce cas, l'intégration de boutons générant une vibration lors du toucher par l'utilisateur transforme la pièce plastique constituant la console centrale en objet « intelligent » permettant d'interagir avec le conducteur ou le passager. L'invention trouve également des applications pour les appareils électroménagers pour lesquels les panneaux de commande entièrement lisses nécessitent l'ajout d'une validation de commande.

Plus précisément, l'invention concerne un procédé de fabrication d'une pièce plastique formant une interface de commande homme-machine à l'aide d'un moule d'injection spécifique.

### ÉTAT DE LA TECHNIQUE ANTÉRIEURE

Dans un grand nombre d'appareils électroniques, tels que des équipements électroménagers, des tableaux de bord pour l'automobile, etc., une façade en plastique contient des boutons permettant à l'utilisateur d'interagir avec l'appareil électronique. Par exemple, dans le cas d'un tableau de bord automobile, on peut positionner des boutons pour mettre en route la climatisation, verrouiller les portes ou encore actionner la montée ou descente d'une vitre, entre autres.

Historiquement, ces boutons étaient des boutons poussoirs mécaniques. Ces boutons poussoirs mécaniques nécessitent des étapes d'assemblage et ne s'intègrent pas parfaitement dans les façades plastiques. En particulier, il subsiste toujours un léger jour autour des boutons. Pour cette raison, de plus en plus de concepteurs préfèrent intégrer maintenant des boutons capacitifs, tels que par exemple décrits dans le brevet américain US 9,112,505 B2.

L'utilisation des capteurs capacitifs pour remplacer les boutons poussoirs mécaniques permet d'avoir une surface complètement lisse de la façade, qui est donc plus esthétique, et également un nettoyage plus facile et une robustesse plus grande, grâce à l'absence de pièces en mouvement. De plus, les utilisateurs sont aujourd'hui très familiers des interfaces capacitives grâce à l'utilisation généralisée des écrans tactiles dans les smartphones ou tablettes.

Ces capteurs capacitifs sont particulièrement bien adaptés pour s'intégrer dans des façades décorées par une technologie d'injection plastique telle que la technologie dite IMF (pour « In Mold Forming » en anglais). Le principe de cette technologie est d'imprimer une couche de décoration sur une feuille de plastique. Cette feuille est ensuite découpée, thermoformée si nécessaire, puis surmoulée, pour obtenir une pièce plastique décorée.

Toutefois, un inconvénient majeur de ces boutons capacitifs est que l'utilisateur ne dispose pas d'un retour tactile lors de l'actionnement du bouton. Une solution fréquemment utilisée pour contourner cette difficulté est de générer un son, par exemple un clic, ou un signal lumineux, lorsque l'utilisateur actionne le bouton capacitif pour lui confirmer la prise en compte de la consigne par l'équipement électronique. Cependant, dans des ambiances bruyantes par exemple ou dans des cas où l'utilisateur regarde ailleurs, par exemple pour un conducteur automobile qui actionne un bouton tout en conduisant, ces deux solutions ne conviennent pas.

Aussi, il existe d'autres solutions pour faire un retour vers l'utilisateur, par exemple par le déclenchement d'une vibration que son doigt va percevoir, tel que par exemple décrit dans la demande de brevet américain US 2007/229455 A1.

Les actuateurs classiquement utilisés pour réaliser un retour haptique, tels que les actionneurs de bobine mobile (« voice coil actuators » en anglais), les actionneurs piézoélectriques (« piezoelectric actuators » en anglais), les actionneurs de masse excentrique (« eccentric mass actuators » en anglais) et/ou les actionneurs d'aimants mobiles (« moving magnets actuators » en anglais), présentent un encombrement qui, la plupart du temps, ne permet pas de les associer individuellement à chaque bouton. Ainsi, comme décrit dans la demande de brevet américain US 2007/229455 A1, pour un clavier comportant plusieurs touches, on dispose un actuateur qui va faire vibrer l'ensemble du clavier.

Ce principe est bien adapté dans le cas de dispositifs électroniques de petite taille assez rigides, tels que les smartphones. En revanche, il comporte des limites : tout d'abord, lorsque la façade est composée d'un matériau qui amortit beaucoup les vibrations, il va falloir générer beaucoup de vibrations pour qu'elles ne soient pas trop amorties et restent perceptibles pour l'utilisateur; de plus, lorsque la façade est complètement encastrée, la mettre en vibration sera compliqué; ensuite, dans le cas d'utilisation multitouches, il serait préférable de réaliser une vibration localisée plutôt qu'une vibration de l'ensemble de la pièce.

Face à ces contraintes, on peut utiliser des actuateurs piézoélectriques réalisés en couches minces tels que décrits par exemple dans la demande internationale WO 2016/024066 A1. L'intérêt de ces actuateurs est qu'ils sont très minces et qu'on peut donc les intégrer directement dans la façade. On peut notamment penser à les imprimer directement sur le film de décoration, et à les surmouler. Toutefois, si on fait cela, les actuateurs sont complètement encastrés dans la pièce plastique, et on ne perçoit pas de vibration lorsqu'ils sont alimentés. WO 2013/058708 A1 divulgue un procédé de fabrication d'une interface de commande homme-machine et se propose de minimiser le problème de fissuration des pistes conductrices dans les zones de détection profilées.

### EXPOSÉ DE L'INVENTION

L'invention a donc pour but de remédier au moins partiellement aux besoins mentionnés précédemment et aux inconvénients relatifs aux réalisations de l'art antérieur.

L'invention a ainsi pour objet, selon l'un de ses aspects, un procédé de fabrication d'une pièce plastique formant une interface de commande homme-machine, selon la revendication 1.

Le procédé de fabrication selon l'invention peut en outre comporter l'une ou plusieurs des caractéristiques suivantes prises isolément ou suivant toutes combinaisons techniques possibles.

Le film de décoration peut présenter une épaisseur comprise entre 100 µm et 2 mm, préférentiellement entre 250 µm et 1 mm.

Le procédé peut comporter une étape de thermoformage du film de décoration.

Par ailleurs, le film de décoration et le film technique peuvent être assemblés ensemble par le biais d'une couche adhésive.

Le pavé d'appui peut être configuré pour former une zone libre, dépourvue de matériau plastique dans la pièce plastique, de forme circulaire et présentant un diamètre compris entre 5 et 40 mm.

En outre, le pavé d'appui peut être monté sur un organe de rappel élastique, notamment un ressort, au sein de la partie inférieure du moule d'injection.

Le moule d'injection peut être en acier trempé.

Le pavé d'appui peut comporter un usinage pour recevoir au moins partiellement ladite pièce d'anti-déformation.

De plus, à l'issue de l'étape d'éjection de la pièce plastique, le procédé comporte l'étape consistant à remplir la zone libre, dépourvue de matériau plastique et formée par le pavé d'appui, par un matériau souple, notamment un matériau caoutchouteux, présentant un module de Young inférieur à 1 GPa, notamment inférieur à 100 MPa.

En outre, à l'issue de l'étape d'éjection de la pièce plastique, le procédé peut comporter l'étape consistant insérer dans la zone libre, dépourvue de matériau plastique et formée par le pavé d'appui, une paroi de solidité mécanique à distance du film d'interface. La distance séparant le film d'interface et la paroi de solidité mécanique peut être comprise entre 0,3 et 1 mm.

Par ailleurs, les actionneurs haptiques de la couche d'actionneurs haptiques peuvent être configurés pour fonctionner en tant que capteurs haptiques de sorte que l'interface formée par le film de décoration comporte un ou plusieurs boutons sensibles à la pression.

Le procédé peu encore comporter la découpe de la couche d'actionneurs haptiques et d'une éventuelle couche adhésive entre la couche d'actionneurs haptiques et la couche de capteurs capacitifs.

De plus, le procédé peut comporter l'étape consistant à insérer un connecteur de type force d'insertion nulle, ou encore ZIF pour « zéro insertion force » en anglais, au niveau de la découpe de la couche d'actionneurs haptiques.

### BRÈVE DESCRIPTION DES DESSINS

L'invention pourra être mieux comprise à la lecture de la description détaillée qui va suivre, d'exemples de mise en oeuvre non limitatifs de celle-ci, ainsi qu'à l'examen des figures, schématiques et partielles, du dessin annexé, sur lequel :
- la figure 1 illustre partiellement un exemple de réalisation d'un procédé de fabrication d'une pièce plastique formant une interface de commande homme-machine conforme à l'invention,
- la figure 2 illustre, partiellement en coupe, un exemple de pièce plastique obtenue par le procédé illustré sur la figure 1,
- la figure 3 illustre, partiellement en coupe, un autre exemple de pièce plastique obtenue par le procédé illustré sur la figure 1 avec présence d'une cloque,
- la figure 4 illustre partiellement un autre exemple de réalisation d'un procédé de fabrication d'une pièce plastique formant une interface de commande homme-machine conforme à l'invention,
- les figures 5 à 8 illustrent, partiellement en coupe, des variantes de réalisation de pièces plastiques obtenues par un procédé de fabrication conforme à l'invention semblable à celui illustré par la figure 4, et
- la figure 9 est une vue partielle de dessus de la figure 8.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

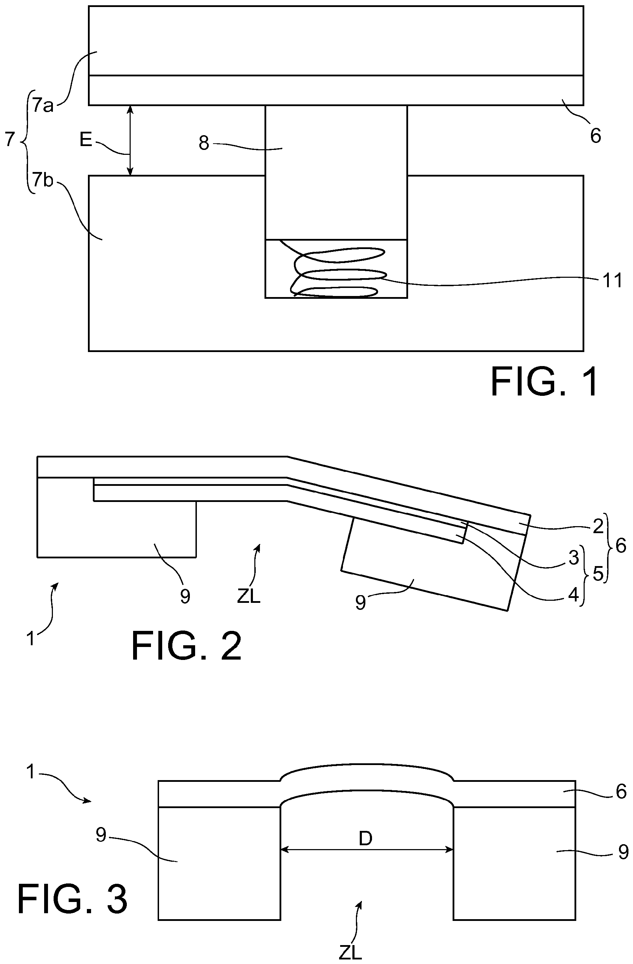

On va décrire ci-après, en référence aux figures 1 à 9, des exemples de réalisation de pièces plastiques 1 obtenues par des procédés de fabrication conformes à l'invention.

Afin de répondre aux problématiques soulevées par les solutions de l'art antérieur, l'invention permet avantageusement de modifier la méthode d'obtention de la pièce plastique 1 lors du surmoulage.

Comme visible sur la figure 1 et sur la figure 2, le procédé selon l'invention consiste à former un film d'interface 6, comprenant un film de décoration 2 et une couche d'actionneurs haptiques 5, qui est ensuite placé dans un moule d'injection 7 pourvu d'un pavé d'appui 8 destiné à former une zone libre ZL dans le matériau plastique 9 de la pièce plastique 1 au niveau des actionneurs haptiques.

Ainsi, le procédé consiste tout d'abord à former le film de décoration 2 qui servira d'interface visible pour un utilisateur et sur lequel pourront être formés des boutons d'actionnement.

Ce film de décoration 2 peut être en polycarbonate, et peut être obtenu par une impression par sérigraphie. Le film de décoration présente une épaisseur comprise entre 100 µm et 2 mm, notamment entre 250 µm et 1 mm, par exemple égale à 380 µm, de façon à permettre la vibration des actionneurs haptiques tout en conservant une certaine rigidité de la pièce plastique 1 au niveau de la zone libre ZL formée par le pavé d'appui 8. De façon facultative, ce film de décoration 2 peut être thermoformé.

Le film de décoration 2 peut également être découpé pour constituer un insert qui sera placé dans le moule d'injection 7.

Par ailleurs, le procédé comprend la formation d'un film technique 5 comprenant une couche d'actionneurs haptiques 3 et une couche de capteurs capacitifs 4. Pour ce faire, des actionneurs haptiques, ou piézoélectriques, et des capteurs capacitifs, ou électrodes, peuvent être imprimés sur un film, par exemple en polyester ou en polycarbonate, par exemple d'épaisseur de l'ordre de 125 µm. De cette façon, on obtient le film technique 5.

Ce film technique 5 peut être déposé directement sur le film de décoration 2. Dans le cas où le film de décoration 2 doit être thermoformé, il peut être avantageux de déposer le film technique 5 sur le film de décoration 2 avant l'étape de thermoformage, lorsque le film de décoration 2 est encore plat, et de procéder ensuite au thermoformage.

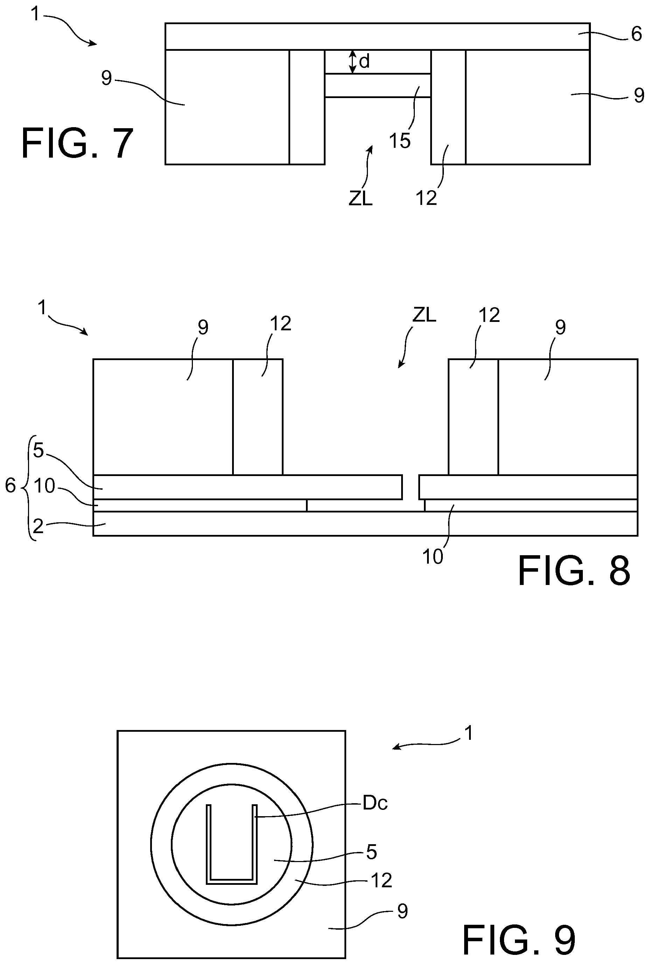

Le film technique 5 peut encore être rapporté sur le film de décoration 2 au moyen d'une couche adhésive 10, comme visible sur la figure 8. Cette couche adhésive 10 est avantageusement configurée pour pouvoir supporter les contraintes thermiques et mécaniques lors de l'étape d'injection du matériau plastique 9. Il peut par exemple s'agir d'un ruban à transfert d'adhésif de type 467 MP de la société 3M. Ainsi, la couche adhésive 10 peut être laminée sur le film technique 5. La couche adhésive 10 peut par exemple avoir une épaisseur de l'ordre de 50 µm. Dans ce cas également, le collage du film technique 5 sur le film de décoration 2 peut être effectué avant une étape de thermoformage du film de décoration 2, ou bien alors après une étape de thermoformage.

Ainsi, l'assemblage du film de décoration 2 et du film technique 5 permet l'obtention d'un film d'interface 6, comme représenté sur la figure 1.

Ce film d'interface 6 est ensuite positionné dans un moule d'injection 7. Ce moule d'injection 7 comprend une partie supérieure 7a appelée contre moule et une partie inférieure 7b appelée matrice, cette dernière constituant la partie mobile du moule 7. Ce moule d'injection 7 est préférentiellement réalisé en acier trempé.

Le film d'interface 6 est placé au contact de la partie supérieure 7a. Il est maintenu par le biais de lignes d'aspiration.

La partie inférieure 7b du moule d'injection 7 comprend un pavé d'appui 8 mobile qui est apte à venir au contact du film d'interface 6 au niveau de la couche d'actionneurs haptiques 3 de sorte qu'une épaisseur E est laissée libre entre le film d'interface 6 et la partie inférieure 7b du moule 7 en dehors du pavé d'appui 8.

Le pavé d'appui 8 est préférentiellement métallique. Il peut se présenter sous la forme d'un cylindre de diamètre compris entre 5 et 40 mm, par exemple. Ainsi, il peut permettre la formation d'une zone libre ZL, dépourvue de matériau plastique 9 dans la pièce plastique 1, de forme circulaire et présentant un diamètre D compris entre 5 et 40 mm, comme visible sur la figure 3 par exemple. Bien entendu, le pavé d'appui 8 peut présenter en section une autre forme que circulaire, par exemple polygonale, par exemple rectangulaire ou carrée.

Le pavé d'appui 8 est ainsi situé en vis-à-vis des actionneurs haptiques et va empêcher le matériau plastique 9 injecté de venir couler au niveau des actionneurs haptiques.

Avantageusement, le pavé d'appui 8 est monté sur un organe de rappel élastique, notamment un ressort 11, au sein de la partie inférieure 7b du moule d'injection 7. De cette façon, cela permet d'obtenir une bonne étanchéité et donc d'éviter que le matériau plastique 9 injecté ne s'infiltre le long de la surface libre des actionneurs, tout en évitant de venir poinçonner le film d'interface 6 et couper les contacts.

Le moule 7 est alors fermé, la force de fermeture étant liée à la surface projetée de la pièce et au matériau injecté. Puis, une injection du matériau plastique 9 est réalisée dans l'épaisseur E libre de part et d'autre du pavé d'appui 8.

Le matériau plastique 9 injecté est préférentiellement du polycarbonate. Il peut par exemple s'agir de polycarbonate haute fluidité, par exemple de type Makrolon^{®} 2207 ou Makrolon^{®} 2407 de la société Plastics Covestro.

La température d'injection peut être comprise entre 260 et 300°C. La pression d'injection est liée à la pièce mais peut de façon générale être comprise entre 300 et 600 bars. La pression de maintien est liée à la pièce mais peut de façon générale être comprise entre 800 et 1000 bars. La température du moule d'injection 7 peut être comprise entre 60 et 80°C.

Ensuite, le moule d'injection 7 est ouvert et la pièce plastique 1 est éjectée.

On obtient ainsi une pièce plastique 1 par exemple du type de celle illustrée sur la figure 2. La zone ZL derrière les actionneurs haptiques est donc laissée libre par le biais d'une modification de l'outillage utilisé lors de l'injection plastique de façon à ce que la matière plastique injectée ne vienne pas au niveau des actionneurs.

Ainsi, l'invention permet d'intégrer des actionneurs haptiques sur un film plastique souple muni d'un film de décoration, tout en conservant les propriétés haptiques, à savoir la vibration de la surface lors d'une action de l'utilisateur, et les contraintes esthétiques imposées par le fabricant, à savoir par le biais de l'intégration d'un film de décoration et l'absence de déformation lié au retrait observé lors du refroidissement de la pièce plastique 1 et du film surmoulé, comme expliqué ci-après en référence à la figure 3.

En effet, à l'issue de l'étape d'injection, suivant le retrait du matériau plastique 9 injecté, il est possible qu'apparaisse à la surface de la pièce plastique 1 une légère cloque, comme visible sur la figure 3.

Pour certains équipements, cette cloque n'est pas acceptable d'un point de vue esthétique. Il ne faut pas sentir sa présence au toucher. Le seuil de sensibilité à une stimulation mécanique de la peau correspond à un enfoncement de 5 µm et il faut pouvoir faire en sorte que la déformation maximale liée au retrait du matériau plastique 9 injecté soit inférieure à cette valeur.

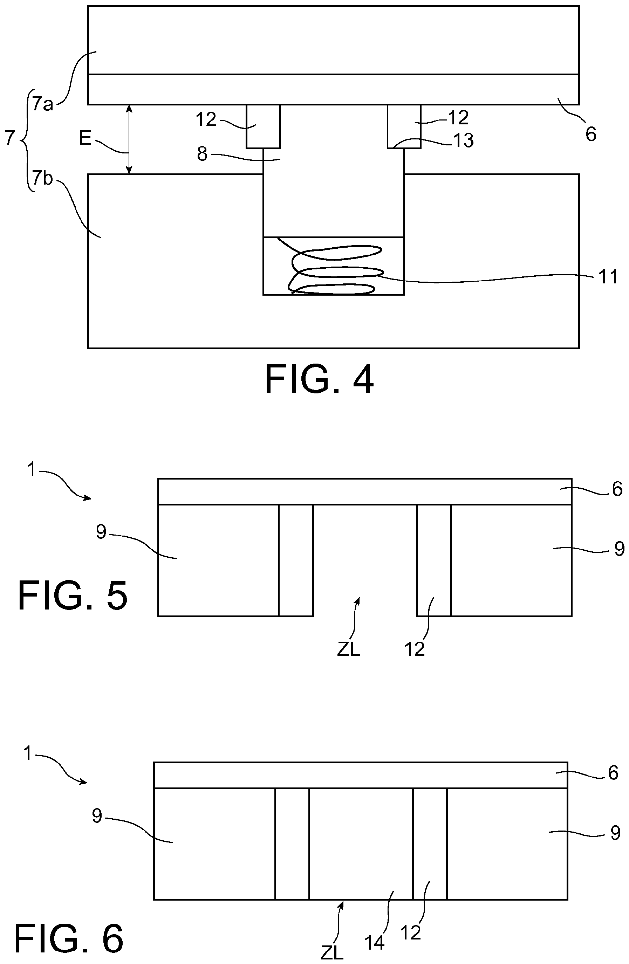

Ainsi, pour éviter cette déformation, avant l'étape d'injection du matériau plastique 9, le procédé peut comporter l'étape de positionnement d'une pièce d'anti-déformation 12 au contact du film d'interface 6 en superposition du pavé d'appui 8, destinée à être située dans la zone libre ZL de la pièce plastique 1 formée par le pavé d'appui 8, comme illustré par la figure 4.

Cette pièce d'anti-déformation 12 va venir empêcher le retrait de la matière injectée et supprimer l'apparition de toute cloque.

La pièce d'anti-déformation est ainsi positionnée dans le contre moule 7a, comme illustré sur la figure 4, et le pavé d'appui 8 peut comporter un usinage 13 pour pouvoir la recevoir.

La pièce d'anti-déformation 12 peut être une pièce annulaire, par exemple une rondelle ou une coupelle. Elle est avantageusement métallique. Elle peut encore être une pièce plastique injectée dans un matériau stable thermiquement, par exemple du polyamide chargé en fibres de verre, des billes de verre, du polytéréphtalate de butylène (PBT), du polyétheréthercétone (PEEK), entre autres, qui ne va pas se déformer lors du refroidissement de la pièce 1.

Dans le cas d'une pièce d'anti-déformation 12 annulaire creuse, l'espace creux de la pièce peut être rempli par un matériau durcissable, par exemple au cours d'une nouvelle étape de surmoulage ou en réalisant un dépôt d'un matériau apte à durcir, par exemple silicone ou polyuréthane. La pièce d'anti-déformation 12 peut être lisse ou présenter des cannelures ou une gorge de façon à la maintenir en place pendant le retrait.

L'ajout d'une telle pièce 12 stable thermiquement dans la zone libre ZL où se situent les actionneurs haptiques permet d'éviter l'apparition de toute cloque susceptible de se former au-dessus de la zone libre ZL lors du refroidissement de la pièce 1, après injection. Les figures 5 à 8 illustrent ainsi des exemples de pièces plastiques 1 obtenues par l'ajout d'une telle pièce d'anti-déformation 12.

Dans certains cas, il est à craindre que la zone libre ZL puisse être enfoncée et/ou déchirée lors d'une mauvaise utilisation. Il est alors utile d'ajouter un élément de solidité mécanique derrière les actionneurs haptiques tout en laissant une surface libre pour qu'ils puissent émettre une vibration perceptible.

Ainsi, comme illustré par la figure 6, à l'issue de l'étape d'éjection de la pièce plastique 1, le procédé peut comporter l'étape consistant à remplir la zone libre ZL par un matériau souple 14, notamment un matériau caoutchouteux, par exemple du polydiméthylsiloxane (PDMS), présentant un faible module de Young inférieur à 1 GPa, notamment inférieur à 100 MPa.

Il est encore possible, comme illustré par la figure 7, de prévoir, à l'issue de l'étape d'éjection de la pièce plastique 1, une étape consistant insérer dans la zone libre ZL une paroi de solidité mécanique 15 à distance du film d'interface 6. Cette paroi 15 peut être pleine ou ajourée, et peut être en métal ou en plastique. La distance d séparant le film d'interface 6 et la paroi de solidité mécanique 15 est préférentiellement comprise entre 0,3 et 1 mm.

Avantageusement, cette paroi 15 sert de fond et permet d'éviter l'enfoncement lors de l'utilisation des actionneurs haptiques. Le doigt de l'utilisateur sera bloqué par cette paroi 15 évitant la détérioration du film de décoration 2.

Par ailleurs, comme l'illustrent les figures 8 et 9, le procédé peut également comporter la découpe De de la couche d'actionneurs haptiques 3 et d'une éventuelle couche adhésive 10 entre la couche d'actionneurs haptiques 3 et la couche de capteurs capacitifs 4. Cette découpe peut être une découpe au laser. Ainsi, procédé peut comporter l'étape consistant à insérer un connecteur de type force d'insertion nulle, ou encore ZIF pour « zéro insertion force » en anglais, au niveau de la découpe de la couche d'actionneurs haptiques 3.

Bien entendu, l'invention n'est pas limitée aux exemples de réalisation qui viennent d'être décrits. Diverses modifications peuvent y être apportées par l'homme du métier.

En particulier, il est à noter que les actionneurs haptiques de la couche d'actionneurs haptiques 3 peuvent être configurés pour fonctionner en tant que capteurs haptiques de sorte que l'interface formée par le film de décoration 2 comporte un ou plusieurs boutons sensibles à la pression. Dans ce cas, lorsque l'utilisateur vient appuyer sur un bouton sensible à la pression du film de décoration 2, le fait qu'il y ait une zone libre ZL derrière les capteurs haptiques leur permet de se déformer et de générer des charges électriques qui peuvent être mesurées par une électronique de lecture.

## Revendications

1. Procédé de fabrication d'une pièce plastique (1) formant une interface de commande homme-machine, comportant les étapes suivantes :
- formation d'un film de décoration (2) destiné à former l'interface visible,
- formation d'un film technique (5) comprenant une couche d'actionneurs haptiques (3) et une couche de capteurs capacitifs (4),
- assemblage du film de décoration (2) et du film technique (5) pour former un film d'interface (6),
- positionnement du film d'interface (6) dans un moule d'injection (7), comprenant une partie supérieure (7a) au contact de laquelle le film d'interface (6) est maintenu par aspiration et une partie inférieure (7b) comprenant un pavé d'appui (8) mobile apte à venir au contact du film d'interface (6) au niveau de la couche d'actionneurs haptiques (3) de sorte qu'une épaisseur (E) est laissée libre entre le film d'interface (6) et la partie inférieure (7b) du moule d'injection (7) en dehors du pavé d'appui (8),
- injection d'un matériau plastique (9) dans l'épaisseur (E) libre de part et d'autre du pavé d'appui (8),
- ouverture du moule d'injection (7) et éjection de la pièce plastique (1) formée,
**caractérisé en ce que**, avant l'étape d'injection du matériau plastique (9), le procédé comporte l'étape de positionnement d'une pièce d'anti-déformation (12) au contact du film d'interface (6) en superposition du pavé d'appui (8), ladite pièce d'anti-déformation (12) étant destinée à être située dans la zone libre (ZL) de la pièce plastique (1) formée par le pavé d'appui (8).

2. Procédé selon la revendication 1, **caractérisé en ce que** le film de décoration (2) présente une épaisseur comprise entre 100 µm et 2 mm, notamment entre 250 µm et 1 mm.

3. Procédé selon la revendication 1 ou 2, **caractérisé en ce qu'**il comporte une étape de thermoformage du film de décoration (2).

4. Procédé selon l'une des revendications précédentes, **caractérisé en ce que** le film de décoration (2) et le film technique (5) sont assemblés ensemble par le biais d'une couche adhésive (10).

5. Procédé selon l'une quelconque des revendications précédentes, **caractérisé en ce que** le pavé d'appui (8) est configuré pour former une zone libre (ZL), dépourvue de matériau plastique (9) dans la pièce plastique (1), de forme circulaire et présentant un diamètre (D) compris entre 5 et 40 mm.

6. Procédé selon l'une quelconque des revendications précédentes, **caractérisé en ce que** le pavé d'appui (8) est monté sur un organe de rappel élastique (11) au sein de la partie inférieure (7b) du moule d'injection (7).

7. Procédé selon l'une quelconque des revendications précédentes, **caractérisé en ce que** le moule d'injection (7) est en acier trempé.

8. Procédé selon l'une quelconque des revendications précédentes, **caractérisé en ce que** le pavé d'appui (8) comporte un usinage (13) pour recevoir au moins partiellement ladite pièce d'anti-déformation (12).

9. Procédé selon l'une quelconque des revendications précédentes, **caractérisé en ce que**, à l'issue de l'étape d'éjection de la pièce plastique (1), le procédé comporte l'étape consistant à remplir la zone libre (ZL), dépourvue de matériau plastique (9) et formée par le pavé d'appui (8), par un matériau souple (14), notamment un matériau caoutchouteux, présentant un module de Young inférieur à 1 GPa, notamment inférieur à 100 MPa.

10. Procédé selon l'une quelconque des revendications 1 à 8, **caractérisé en ce que**, à l'issue de l'étape d'éjection de la pièce plastique (1), le procédé comporte l'étape consistant insérer dans la zone libre (ZL), dépourvue de matériau plastique (9) et formée par le pavé d'appui (8), une paroi de solidité mécanique (15) à distance du film d'interface (6).

11. Procédé selon la revendication 10, **caractérisé en ce que** la distance (d) séparant le film d'interface (6) et la paroi de solidité mécanique (15) est comprise entre 0,3 et 1 mm.

12. Procédé selon l'une quelconque des revendications précédentes, **caractérisé en ce que** les actionneurs haptiques de la couche d'actionneurs haptiques (3) sont configurés pour fonctionner en tant que capteurs haptiques de sorte que l'interface formée par le film de décoration (2) comporte un ou plusieurs boutons sensibles à la pression.

13. Procédé selon l'une quelconque des revendications précédentes, **caractérisé en ce qu'**il comporte la découpe de la couche d'actionneurs haptiques (3) et d'une éventuelle couche adhésive (10) entre la couche d'actionneurs haptiques (3) et la couche de capteurs capacitifs (4).

14. Procédé selon la revendication 13, **caractérisé en ce qu'**il comporte l'étape consistant à insérer un connecteur de type force d'insertion nulle, ou encore ZIF pour « zero insertion force » en anglais, au niveau de la découpe de la couche d'actionneurs haptiques (3).

## Patentansprüche

1. Verfahren zum Herstellen eines Kunststoffteils (1), das eine Mensch-Maschine-Steuerungsschnittstelle bildet, umfassend die folgenden Schritte:
- Bilden einer Dekorfolie (2), die dazu bestimmt ist, die sichtbare Schnittstelle zu bilden,
- Bilden einer technischen Folie (5), die eine Schicht aus haptischen Aktoren (3) und eine Schicht aus kapazitiven Sensoren (4) umfasst,
- Zusammenfügen der Dekorfolie (2) und der technischen Folie (5) zu einer Schnittstellenfolie (6),
- Positionieren der Schnittstellenfolie (6) in einer Spritzgussform (7), die einen oberen Teil (7a), mit dem die Schnittstellenfolie (6) durch Saugkraft in Kontakt steht, und einen unteren Teil (7b) umfasst, der einen beweglichen Stützblock (8) umfasst, der dazu geeignet ist, mit der Schnittstellenfolie (6) auf Höhe der Schicht aus haptischen Aktoren (3) in Kontakt zu kommen, so dass eine Dicke (E) zwischen der Schnittstellenfolie (6) und dem unteren Teil (7b) der Spritzgussform (7) außerhalb des Stützblocks (8) freigelassen wird,
- Einspritzen eines Kunststoffmaterials (9) in die freie Dicke (E) auf beiden Seiten des Stützblocks (8),
- Öffnen der Spritzgussform (7) und Auswerfen des geformten Kunststoffteils (1),
**dadurch gekennzeichnet, dass** das Verfahren vor dem Schritt des Einspritzens des Kunststoffmaterials (9) den Schritt des Positionierens eines Anti-Verformungsteils (12) in Kontakt mit der Schnittstellenfolie (6) in Überlagerung mit dem Stützblock (8) aufweist, wobei das Anti-Verformungsteil (12) dazu bestimmt ist, sich in der freien Zone (ZL) des durch den Stützblock (8) gebildeten Kunststoffteils (1) zu befinden.

2. Verfahren nach Anspruch 1, **dadurch gekennzeichnet, dass** die Dekorfolie (2) eine Dicke zwischen 100 µm und 2 mm, insbesondere zwischen 250 µm und 1 mm aufweist.

3. Verfahren nach Anspruch 1 oder 2, **dadurch gekennzeichnet, dass** es einen Schritt des Thermoformens der Dekorfolie (2) umfasst.

4. Verfahren nach einem der vorhergehenden Ansprüche, **dadurch gekennzeichnet, dass** die Dekorfolie (2) und die technische Folie (5) mit Hilfe einer Klebeschicht (10) miteinander verbunden werden.

5. Verfahren nach einem der vorhergehenden Ansprüche, **dadurch gekennzeichnet, dass** der Stützblock (8) dazu eingerichtet ist, eine kreisförmige freie Zone (ZL), die kein Kunststoffmaterial (9) enthält, mit einem Durchmesser (D) zwischen 5 und 40 mm im Kunststoffteil (1) zu bilden.

6. Verfahren nach einem der vorhergehenden Ansprüche, **dadurch gekennzeichnet, dass** der Stützblock (8) im unteren Teil (7b) der Spritzgussform (7) an einem elastischen Rückstellelement (11) angebracht ist.

7. Verfahren nach einem der vorhergehenden Ansprüche, **dadurch gekennzeichnet, dass** die Spritzgussform (7) aus gehärtetem Stahl gefertigt ist.

8. Verfahren nach einem der vorhergehenden Ansprüche, **dadurch gekennzeichnet, dass** der Stützblock (8) eine Formgebung (13) umfasst, um das Anti-Verformungsteil (12) zumindest teilweise aufzunehmen.

9. Verfahren nach einem der vorhergehenden Ansprüche, **dadurch gekennzeichnet, dass** das Verfahren am Ende des Schritts des Auswerfens des Kunststoffteils (1) den Schritt umfasst, der darin besteht, die freie Zone (ZL), die kein Kunststoffmaterial (9) enthält und durch den Stützblock (8) gebildet ist, mit einem weichen Material (14), insbesondere einem gummiartigen Material mit einem Elastizitätsmodul von weniger als 1 GPa, insbesondere weniger als 100 MPa, zu füllen.

10. Verfahren nach einem der Ansprüche 1 bis 8, **dadurch gekennzeichnet, dass** das Verfahren am Ende des Schritts des Auswerfens des Kunststoffteils (1) den Schritt umfasst, der darin besteht, in die freien Zone (ZL), die kein Kunststoffmaterial (9) enthält und durch den Stützblock (8) gebildet ist, eine Wand (15) mit mechanischer Festigkeit einzufügen, die von der Schnittstellenfolie (6) beabstandet ist.

11. Verfahren nach Anspruch 10, **dadurch gekennzeichnet, dass** der Abstand (d), der die Schnittstellenfolie (6) und die Wand (15) mit mechanischer Festigkeit trennt, zwischen 0,3 und 1 mm beträgt.

12. Verfahren nach einem der vorhergehenden Ansprüche, **dadurch gekennzeichnet, dass** die haptischen Aktoren der Schicht aus haptischen Aktoren (3) dazu eingerichtet sind, als haptische Sensoren zu fungieren, so dass die durch die Dekorfolie (2) gebildete Schnittstelle eine oder mehrere druckempfindliche Tasten aufweist.

13. Verfahren nach einem der vorhergehenden Ansprüche, **dadurch gekennzeichnet, dass** es das Schneiden der Schicht aus haptischen Aktoren (3) und einer möglichen Klebeschicht (10) zwischen der Schicht aus haptischen Aktoren (3) und der Schicht aus kapazitiven Sensoren (4) umfasst.

14. Verfahren nach Anspruch 13, **dadurch gekennzeichnet, dass** es den Schritt des Einfügens eines Verbinders vom Typ Nullkraftsockel, oder auch ZIF für "Zero Insertion Force" auf Englisch, auf Höhe des Ausschnitts der Schicht aus haptischen Aktoren (3) umfasst.

## Claims

1. Method for manufacturing a plastic part (1) forming a human-machine control interface, comprising the following steps:
- formation of a decorative film (2) intended to form the visible interface,
- formation of a technical film (5) including a layer of haptic actuators (3) and a layer of capacitive sensors (4),
- assembly of the decorative film (2) and the technical film (5) to form an interface film (6),
- positioning of the interface film (6) in an injection mould (7), including an upper portion (7a) with which the interface film (6) is maintained in contact by suction and a lower portion (7b) including a moveable support pad (8) capable of coming into contact with the interface film (6) at the level of the layer of haptic actuators (3) such that a thickness (E) is left free between the interface film (6) and the lower portion (7b) of the injection mould (7) outside of the support pad (8),
- injection of a plastic material (9) into the free thickness (E) on either side of the support pad (8),
- opening of the injection mould (7) and ejection of the plastic part formed,
**characterized in that**, prior to the step of injection of the plastic material (9), the method comprises the step of positioning an anti-deformation part (12) in contact with the interface film (6) in superposition with the support pad (8), said anti-deformation part (12) being intended to be located in the free zone (ZL) of the plastic part (1) formed by the support pad (8).

2. Method according to claim 1, **characterized in that** the decorative film (2) has a thickness comprised between 100 µm and 2 mm especially between 250 µm and 1 mm.

3. Method according to claim 1 or 2, **characterized in that** the method comprises a step of thermoforming the decorative film (2).

4. Method according to one of the preceding claims **characterized in that** the decorative film (2) and the technical film (5) are assembled together by means of an adhesive layer (10).

5. Method according to any one of the preceding claims, **characterized in that** the support pad (8) is configured to form a free zone (ZL), devoid of plastic material (9) in the plastic part (1), of circular shape and having a diameter comprised between 5 and 40 mm.

6. Method according to any one of the preceding claims, **characterized in that** the support pad (8) is mounted on an elastic return member (11) within the lower portion (7b) of the injection mould (7).

7. Method according to any one of the preceding claims, **characterized in that** the injection mould (7) is made of tempered steel.

8. Method according to any one of the preceding claims, **characterized in that** the support pad (8) comprises a machining (13) to receive at least partially said anti-deformation part (12).

9. Method according to any one of the preceding claims, **characterized in that** at the end of the step of ejection of the plastic part (1), the method comprises the step consisting in filling the free zone (ZL), devoid of plastic material (9) and formed by the support pad (8), with a flexible material (14), having a Young's modulus less than 1 GPa especially less than 100 MPa

10. Method according to any one of claims 1 to 8, **characterized in that**, at the end of the step of ejection of the plastic part, the method comprises the step consisting in inserting into the free zone (ZL), devoid of plastic material (9) and formed by the support pad (8), a mechanically robust wall (15) at a distance from the interface film (6).

11. Method according to claim 10, **characterized in that** the distance (d) separating the interface film (6) and the mechanically robust wall (15) is comprised between 0.3 and 1 mm.

12. Method according to any one of the preceding claims, **characterized in that** the haptic actuators (3) of the layer of haptic actuators are configured to operate as haptic sensors such that the interface formed by the decorative film comprises (2) one or more pressure sensitive buttons.

13. Method according to any one of the preceding claims **characterized in that** the method comprises the cutting of the layer of haptic actuators (3) and an adhesive layer (10) between the layer of haptic actuators (3) and the layer of capacitive sensors (4).

14. Method according to claim 13, **characterized in that** the method comprises the step consisting in inserting a ZIF (zero insertion force) type connector, at the level of the cutting of the layer of haptic actuators (3).
